# EUROPEAN PATENT APPLICATION

(11) **EP 4 739 018 A1**
(43) Date of publication of application: **06.05.2026**
(21) Application number: 25212512.5
(22) Date of filing: 30.10.2025
(51) Int. Cl.: H05K 7/20

(54) **COOLING DISTRIBUTION UNIT WITH CONSTANT PRESSURE AND VARIABLE FLOW**

(30) Priority: 01.11.2024 US 202463715136 P
(71) Applicant: Carrier Corporation, Palm Beach Gardens, FL 33418 (US)
(72) Inventor: GRABON, Michel, 01120 Montluel (FR); FERVEL, Pierre Alain, 01120 Montluel (FR)
(74) Representative: Dehns

(57) **Abstract**

A cooling distribution unit associated with at least one rack system of a data center includes a first cooling system having a primary cooling circuit through which a heat transfer fluid is configured to circulate and including a heat exchanger. A second cooling system has a secondary cooling circuit through which a coolant is configured to circulate and includes a pump. The second cooling system is thermally coupled to the first cooling system at the heat exchanger. A pressure at the pump remains constant as a load at the first heat exchanger varies.

## Description

The invention pertains to the art of thermal management, and more particularly, relates to thermal management of a server within a data center.

A "data center" refers to the physical location of one or more servers. A data center and the servers housed within a data center typically consume a significant amount of electrical power. Existing servers are designed to be cooled at least partially by a flow of air. Such servers usually include one or more printed circuit boards having a plurality of operable heat-generating devices mounted thereto. The printed circuit boards are commonly housed in an enclosure having vents configured to direct external air from the data center into, through and out of the enclosure. The air absorbs heat dissipated by the components and after being exhausting from the enclosure, mixes with the ambient air. An air conditioner is then used to cool the heated air of the data center and to recirculate it, repeating the cooling process.

Higher performance server components typically dissipate more power. However, the amount of heat that a conventional air-cooled cooling system can remove from a server is in part limited by the extent of the air flow available and air proprieties relative to heat transfer capacity of the air. To increase the power density of a cooling system, liquid cooling is required. Liquid cooling allows significant increase of dissipated heat from servers.

According to a first aspect of the present invention, a cooling distribution unit associated with at least one rack system of a data center includes a first cooling system having a primary cooling circuit through which a heat transfer fluid is configured to circulate and including a heat exchanger. A second cooling system has a secondary cooling circuit through which a coolant is configured to circulate and includes a pump. The second cooling system is thermally coupled to the first cooling system at the heat exchanger. A pressure at the pump remains constant as a load at the first heat exchanger varies.

Optionally, the load at the cooling distribution unit is controlled via operation of the pump.

Optionally, the pump fluidly connected to the secondary cooling circuit is a variable speed pump.

Optionally, a portion of the coolant output from the pump is selectively recirculated to the pump to increase a pressure at the pump.

Optionally, a recirculation conduit has an inlet fluidly connected to the secondary cooling circuit downstream from the pump and an outlet fluidly connected the secondary cooling circuit upstream from the pump.

Optionally, at least one of the inlet is fluidly connected to the secondary cooling circuit directly downstream from the pump and the outlet is fluidly connected the secondary cooling circuit directly upstream from the pump.

Optionally, a valve arranged along the recirculation conduit is operable to control a flow of the coolant returned to an inlet of the pump.

Optionally, the pump is operated within a zone of stable operation as the load at the cooling distribution unit varies.

Optionally, a controller is configured to determine a differential pressure across the heat exchanger.

Optionally, a first sensor is arranged within the secondary cooling circuit upstream from the heat exchanger and a second sensor is arranged within the secondary cooling circuit downstream from the heat exchanger. The first sensor and the second sensor are operably coupled to the controller and are operable to sense a pressure. A difference between the pressure at the first sensor and the pressure at the second sensor being the differential pressure across the heat exchanger.

Optionally, the controller is configured to compare the differential pressure with a differential pressure set point to determine a difference between the differential pressure measured by the first sensor and the second sensor and the differential pressure set point, and adjust at least one operational parameter of the pump in response to the difference between the differential pressure measured by the first sensor and the second sensor and the differential pressure set point.

Optionally, the at least one operational parameter of the pump is speed.

Optionally, the controller is configured to evaluate if operation of the pump with the at least one operational parameter is within the zone of stable operation.

Optionally, the controller is configured to adjust operation of the pump to a minimum flow and pressure required to operate within the zone of stable operation and recirculate a portion of the coolant output from the pump to an inlet of the pump to increase a pressure at the pump.

According to a second aspect of the present invention, a method of operating a cooling distribution unit includes circulating a heat transfer fluid through a primary cooling circuit and circulating a coolant through a secondary cooling circuit. The secondary cooling circuit includes a pump and the cooling distribution circuit and the secondary cooling circuit and thermally coupled via a heat exchanger. The method additionally includes detecting a differential pressure within the secondary cooling circuit and selectively recirculating a flow of coolant within the secondary cooling circuit to the pump to maintain a constant pressure within the secondary cooling circuit.

Optionally, selectively recirculating a flow of the coolant within the secondary cooling circuit to the pump further comprises diverting a portion of the coolant provided at an outlet of the pump directly to an inlet of the pump.

Optionally, comparing the differential pressure to a differential pressure setpoint and determining at least one operational parameter of the pump in response to a difference between the differential pressure and a differential pressure set point.

Optionally, determining that operation of the pump with the at least one operational parameter to determine is within a zone of stable operation associated with the pump and implementing the at least one operational parameter.

Optionally, determining that operation of the pump with the at least one operational parameter to determine is within a zone of instable operation associated with the pump, adjusting operation of the pump to a minimum flow and pressure associated with the zone of stable operation, and opening a valve to recirculate a portion of a flow of the coolant output from the pump to the inlet of the pump.

Optionally, the at least one operational parameter of the pump is speed.

The following descriptions and drawings are provided by way of example only and should not be considered limiting in any way. With reference to the accompanying drawings, like elements are numbered alike:
FIG. 1 is a schematic diagram of an example of a cooling system;
FIG. 2 is a detailed schematic diagram of a cooling distribution unit of the cooling system of FIG. 1;
FIG. 3 is a detailed schematic diagram of a cooling distribution unit of the cooling system of FIG. 1.

A detailed description of one or more embodiments of the disclosed apparatus and method are presented herein by way of exemplification and not limitation with reference to the Figures.

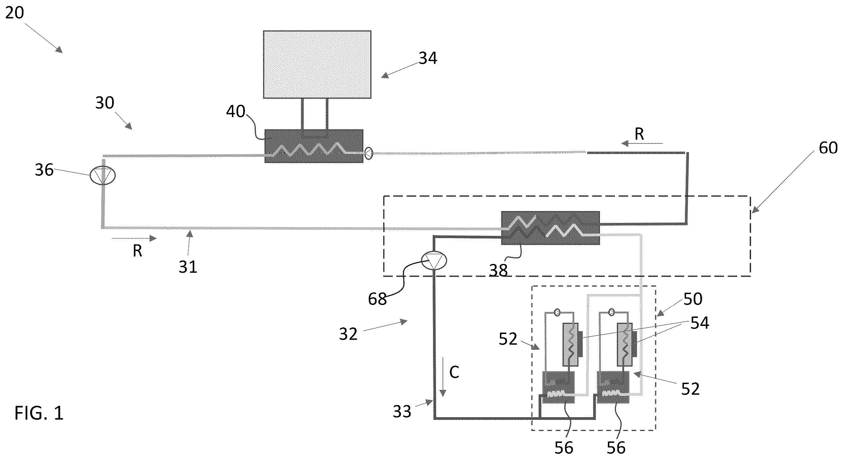

Referring to FIG. 1, an example of a cooling system 20 is. As shown, the cooling system 20 includes a first cooling system 30 and a plurality of loads thermally coupled to the first cooling system 30. As used herein, the term "load" is intended to apply to any secondary system or component that is thermally coupled to the first cooling system 30, regardless of whether the secondary system or component is configured to transfer heat to the first cooling system 30 or remove heat from the first cooling system 30. In the illustrated, non-limiting embodiment, the plurality of loads of the first cooling system 30 includes a first load 32 and a second load 34. However, it should be appreciated that embodiments having any number of loads connected to the first cooling system 30, such as three loads, four loads, or five loads for example, are within the disclosure. Examples of suitable loads include but are not limited to a data center cooling system, an air conditioning system such as an air handling unit, a chiller system, a heat pump, and a sanitary or potable water system.

As shown, the first cooling system 30 includes a primary cooling circuit 31 through which a primary heat transfer fluid R circulates. Examples of suitable heat transfer fluids F include but are not limited to water, propylene glycol, dielectric fluid, and refrigerant. The first cooling system 30 may include a pump or other movement device 36 for moving the heat transfer fluid R through the primary cooling circuit 31. In some embodiments, the primary cooling circuit 31 may include one or more valves (not shown), such as to allow the heat transfer fluid R to selectively bypass one or more of the loads. Although the primary cooling circuit 31 is illustrated as having a closed loop configuration, embodiments where the primary cooling circuit 31 is not a closed loop are also contemplated herein.

The first cooling system 30 is configured to transfer heat between the plurality of loads. In the simplified first cooling system 30 illustrated in the embodiment of FIG. 1, the heat transfer fluid R is configured to absorb heat from the first load 32 and transfer heat to the second load 34. Although the primary cooling circuit 31 is illustrated as being thermally coupled to the one or more loads via heat exchangers, such as a first heat exchanger 38 and a second heat exchanger 40, respectively, it should be appreciated that embodiments where the primary cooling circuit 31 is thermally coupled to the at least one load in another suitable manner are within the scope of the disclosure.

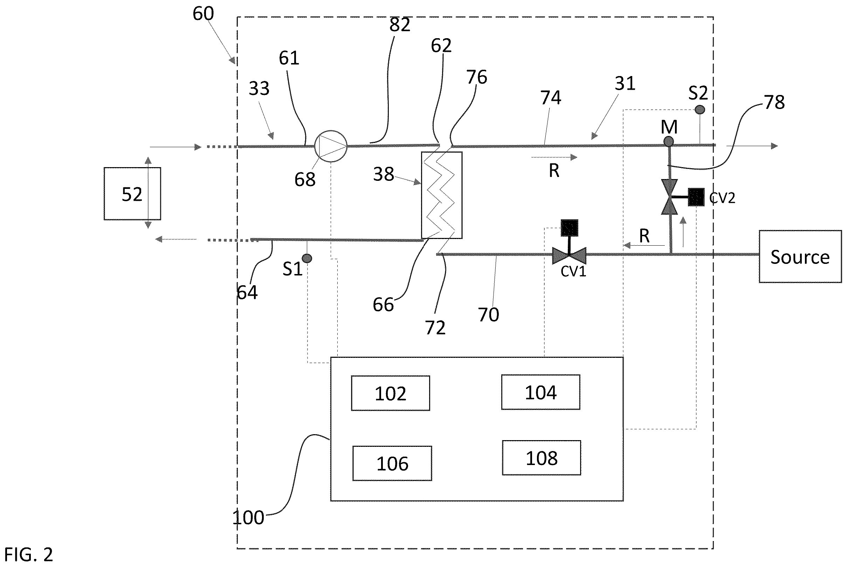

In the illustrated, non-limiting embodiment, the first load 32 is a second cooling system, such as a data center cooling system for example, and includes a secondary cooling circuit 33 through which a coolant or secondary cooling fluid C is configured to circulate. In some embodiments, the coolant C is a liquid, such as water, propylene glycol, or dielectric fluid for example. The second cooling system 32 is associated with one or more data centers 50, each having at least one rack system 52 containing at least one server or assembly having heat-generating electronic devices 54 (referred to herein as "servers") therein (see FIG. 2). Localized cooling at the one or more servers 54 may be performed via a separate server cooling system having a separate fluid, not described herein. As shown, the rack system 52 includes at least one heat recovery component 56 configured to receive a flow of the coolant C. In the illustrated, non-limiting embodiment, the heat recovery component 56 is a heat exchanger. However, in other embodiments the heat recovery component 56 may be a cold plate or other suitable heat transfer device. Within each heat recovery component 56, heat is transferred from the rack system 52, such as from the one or more components of the at least one server 54 arranged therein, to the coolant C. In embodiments where a data center 50 includes a plurality of rack systems 52, as shown in FIG. 1, the coolant C is provided to the heat recovery component 56 associated with each rack system 52 in parallel. The flows of coolant C output from each heat recovery component 56 are then rejoined at a location upstream from the first heat exchanger 38or other thermal coupling with the first cooling system 30. It should be appreciated that in embodiments wherein the second cooling system 32 alternatively or additionally includes a plurality of data centers 50, the coolant C may be provided to each data center 50 in parallel, and further may be provided to the heat recovery component 56 of each rack system 52 of the plurality of data centers 50 in parallel.

With reference now to FIG. 2, a detailed view of a portion of the cooling system 20, also referred to herein as the cooling distribution unit (CDU) 60, is illustrated in more detail. As shown, the cooling distribution unit 60 includes a portion of both the primary cooling circuit 31 and the secondary cooling circuit 33 and the thermal interface therebetween at the first heat exchanger 38. As shown, the portion of the secondary cooling circuit 33 within the CDU 60 includes a first fluid conduit 61 connected to an inlet 62 of a first pathway of the first heat exchanger 38 and a second fluid conduit 64 connected to and extending from an outlet 66 of the first pathway of the first heat exchanger 38. The first fluid conduit 61 is configured to receive heated coolant C from one or more rack systems 52 or components thereof and the second fluid conduit 64 is operable to deliver cooled coolant C to the one or more rack systems 52 or components thereof. As shown, a pump 68 is arranged within the portion of the secondary cooling circuit 33 within the CDU 60 and is operable to circulate the coolant C between the first heat exchanger 38 and the one or more rack systems 52 or components thereof to be cooled. Although the pump 68 is illustrated as being arranged at the first fluid conduit 61, it should be understood that embodiments where the pump 68 is arranged at another location of the secondary cooling circuit 33 within the CDU 60, such as within the second fluid conduit 64 for example, are also within the scope of the disclosure. In an embodiment, the pump 68 is operable at variable speeds such as via a variable frequency drive operably coupled thereto. Although only a single pump is illustrated, it should be understood that in other embodiments, multiple pumps may be used. For example, a plurality of pumps may be arranged in parallel to provide am increase flow or to provide redundancy in a system.

The portion of the primary cooling circuit 31 within the CDU 60 similarly includes a first fluid conduit 70 connected to an inlet 72 of a second pathway of the first heat exchanger 38, and a second fluid conduit 74 connected to and extending from an outlet 76 of the second pathway of the first heat exchanger 38. The first fluid conduit 70 is configured to receive cold heat transfer fluid R from a source and the second fluid conduit 74 is operable to deliver the heated heat transfer fluid R to a downstream cooling system load or other component, such as the second heat exchanger 40.

As previously described a pump 36, not shown in FIG. 2, may be operable to move the flow of heat transfer fluid R through the primary cooling circuit 31. The pump 36, however, may not be arranged within the portion of the primary cooling circuit 31 within the CDU 60. As, shown, the portion of the primary cooling circuit 31 associated with the CDU 60 includes at least one valve operable to control the flow of the heat transfer fluid R therein. In the illustrated, non-limiting embodiment, a first valve CV1 is arranged within the first fluid conduit 70 at a location downstream from the source and upstream from an inlet 72 of the first heat exchanger 38. Although only a single heat exchanger 38 is illustrated in the FIGS., it should be understood that embodiment including multiple heat exchangers, such as arranged in parallel for example, are also contemplated herein. The first valve CV1 is operable to adjust the flow rate of the heat transfer fluid R provided to the first heat exchanger 38.

In some embodiments, the at least one valve of the primary cooling circuit 31 arranged within the CDU 60 additionally includes a second valve CV2. As shown, the second valve CV2 may be arranged within a bypass conduit 78 extending between and fluidly coupling the first fluid conduit 70 to the second fluid conduit 74. The second valve CV2 is adjustable to control a flow of heat transfer fluid R through the bypass conduit 78. In the illustrated, non-limiting embodiment, the bypass conduit 78 is fluidly connected to the first fluid conduit 70 at a location downstream from the source and upstream from the first valve CV1. Accordingly, when the second valve CV2 is open such that heat transfer fluid R is able to pass therethrough, the flow path defined by the bypass conduit 78 is arranged in parallel with the first heat exchanger 38 relative to the first fluid conduit 70. Although the first valve CV1 and second valve CV2 are illustrated and described herein as two-way valves, in other embodiments, the functionality of the first valve CV1 and the second valve CV2 may be integrated into a single three-way valve.

During operation of the cooling system 20, the load at the CDU 60, such as at the first heat exchanger 38 for example, may vary. The first heat exchanger 38 is designed to remove a predetermined amount of heat from the cooling fluid C under certain operating conditions. Operation in this condition, also referred to as maximum load at the first heat exchanger 38, may be associated with a condition where the cooling fluid C is operable to cool all of the rack systems 52 or components thereof during continued operation of such components. However, when only some of the rack systems 52 or components thereof need cooling, such as when some of these rack systems 52 or components thereof are non-operational, the CDU 60 may be considered to be operating under a partial load. As a result, the amount of heat to be removed from the one or more rack systems 52, and therefore the temperature of the coolant C provided to the first heat exchanger 38 may vary.

The load on the first heat exchanger 38, i.e., the amount and rate of heat transfer that occurs between the heat transfer fluid R and the coolant C at the first heat exchanger 38, is determined in part by the volumetric flow in the secondary cooling circuit 33 and the operational speed (rpm) of the pump 68. Therefore, the temperature and/or flow rate of the heat transfer fluid R provided to the first heat exchanger 38 may vary. Because the heat transfer fluid R output from the source and supplied to the inlet 72 of the first heat exchanger 38 has a first, constant temperature, the capacity of the first heat exchanger 38 cannot be controlled by adjusting the temperature of the heat transfer fluid R provided thereto. Accordingly, a position of the first valve CV1 may adjusted to control the flow of the heat transfer fluid R at the first temperature provided to the first heat exchanger 38. For example, the first valve CV1 may be partially closed to reduce the flow of the heat transfer fluid R provided to the first heat exchanger 38 to control the capacity of the first heat exchanger 38.

The temperature of the heat transfer fluid R provided at the outlet 76 of the first heat exchanger 38, also referred to herein as the second temperature of the heat transfer fluid R, will vary as a function of the load at the CDU 60. For example, as the load of the CDU 60 decreases, and therefore the flow of heat transfer fluid R provided to the first heat exchanger 38 decreases, the temperature of the heat transfer fluid R at the outlet 76 of the first heat exchanger 38 increases.

In some applications, the heat transfer fluid R delivered to the downstream load 40 via the second fluid conduit 74 is required to have a predetermined return temperature, also referred to herein as a return temperature setpoint. To counteract the variation in temperature of the heat transfer fluid R that occurs at the first heat exchanger 38 due to variation in the load at the CDU 60, the heat transfer fluid R provided to the second fluid conduit 74 from the first heat exchanger 38 may be mixed at a mixing point M with heat transfer fluid R having the first, constant temperature. The resulting mixture of heat transfer fluid R from the first heat exchanger 38 and the heat transfer fluid R having the first, constant temperature may then be provided to the downstream load 40.

In an embodiment, when the second temperature of the heat transfer fluid R output from the first heat exchanger 38 exceeds the desired return temperature of the heat transfer fluid R, the second valve CV2 may be at least partially opened to divert a portion of the heat transfer fluid R located upstream of the first heat exchanger 38 to the second fluid conduit 74. When the second valve CV2 is at least partially open, the heat transfer fluid R within the first fluid conduit 70 may be divided into a first portion configured to flow to the first heat exchanger 38, and a second portion configured to flow through the flow path defined by the bypass conduit 78 and mix with the first portion of the heat transfer fluid R output from the first heat exchanger 38. Although the first cooling system 30 is illustrated as diverting flow from the first fluid conduit 70, the flow of heat transfer fluid R having the first temperature may be provided to the second fluid conduit 74 directly from the source via a separate conduit.

The first cooling system 30 additionally includes a controller 100 operably coupled to one or more components of the first cooling system 30. As shown, the controller may include a sensor interface 102 that can obtain operational parameters of the first cooling system 30, such as pressures, temperatures, etc. As known in the art, the controller 100 can adjust operation of the first cooling system 30 based on sensed operational parameters. The controller 100 includes a processor 104 that controls operation of the first cooling system 30. The processor 104 may be implemented using a general-purpose microprocessor executing a computer program stored on a storage medium to perform the operations described herein. Alternatively, the processor 104 may be implemented in hardware (e.g., ASIC, FPGA) or in a combination of hardware/software. The processor 104 allows the controller 100 to perform computations locally, also referred to as edge computing. The processor 104 can send commands to other components of the first cooling system 30 based on a result of the local computations.

The controller 100 may include a memory 106 that may store a computer program executable by the processor 104, reference data, sensor data, etc. The memory 106 may be implemented using known devices, such as random access memory. The controller 100 may additionally include a communication unit 108 which allows the controller 100 to communicate with other components of the first cooling system 30. In an embodiment, the controller is operably coupled to and configured to communicate with the plurality of valves CV1, CV2 integrated into the primary cooling circuit 31. The controller 100 may also be operably coupled to and configured to communicate with the pump 68, and one or more valves CV3 of the secondary cooling circuit 33 to be described herein below. The communication unit 108 may be implemented using wired connections (e.g., LAN, ethernet, twisted pair, etc.) and/or wireless connections (e.g., Wi-Fi, near field communications ("NFC"), Bluetooth, etc.).

One or more sensors may be arranged within the cooling system 20 and operably coupled to the controller 100. In an embodiment, at least one sensor, such as a first sensor represented by S1 is operable to monitor the temperature and/or pressure of the cooling fluid C at a location downstream from the first heat exchanger 38 and upstream from the one or more rack systems 52 or other components to be cooled by the cooling fluid C. This temperature data and/or pressure data may be sensed and communicated to the controller 100 from the at least one sensor S1 intermittently or continuously. The controller 100 may be configured to compare the temperature of the coolant C at a location downstream from the first heat exchanger 38 and upstream from the one or more racks 52 or other components to be cooled to a corresponding temperature set point. The controller 100 is then operable to adjust a position of the first valve CV1 in response to this difference between the temperature set point and the sensed temperature. A second sensor, represented at S2, may be operable to monitor the temperature of the heat transfer fluid R at a location downstream from the mixing point M and upstream from the downstream load 40. The controller 100 may be configured to compare the sensed temperature of the heat transfer fluid R downstream from the mixing point M to the return temperature set point. The controller 100 is then operable to adjust a position of the second valve CV2, and therefore control the amount of the cool heat transfer fluid R mixed with the heat transfer fluid R output from the first heat exchanger 38, in response to this difference between the return temperature set point and the temperature sensed at S2. Therefore, the controller 100 is operable to adjust a position of the second valve CV2 to maintain the temperature of the heat transfer fluid R output from the mixing point M at a generally constant return temperature.

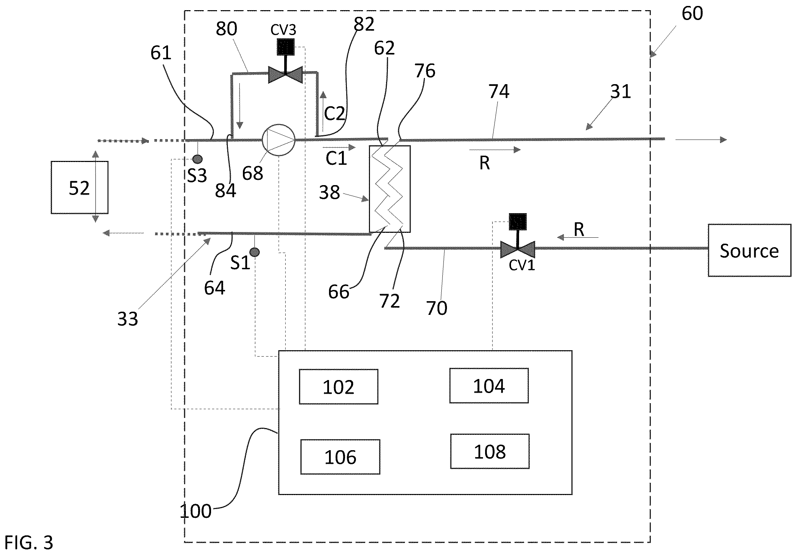

With reference now to FIG. 3, the one or more components of the rack systems 52 to be cooled by the secondary cooling circuit 33 may require a constant differential pressure. Accordingly, the pump 68 of the secondary cooling circuit 33 may be controllable by the controller 100 to provide a predetermined constant pressure, also referred to herein as a differential pressure set point. As the load on the first heat exchanger 38 and/or the flow rate of the coolant C is reduced, the pump speed, and therefore the available static pressure of the pump 68, is also reduced. Due to limitations in the operating envelope of the pump 68, at certain flow rates and/or pump speeds, such as during partial load operating conditions for example, the available static pressure of the pump 68 may be less than the differential pressure set point.

In an embodiment, to provide the additional pressure necessary to reach the differential pressure set point and hold the pressure constant thereat, a portion of the coolant C output from the pump 68 is recirculated to an inlet of the pump 68 such that the coolant C passes therethrough again. As shown, an inlet 82 to a recirculation conduit 80 may be fluidly connected to the first fluid conduit 61 at a location downstream from the pump 68 and upstream from the inlet 62 of the first heat exchanger 38. In the illustrated, non-limiting embodiment, the inlet 82 to the recirculation conduit 80 is fluidly connected to the first fluid conduit 61 directly downstream from the outlet of the pump 68. The outlet end 84 of the recirculation conduit 80 may be fluidly connected to the first fluid conduit 61 at a location downstream from the rack system 52 or one or more components thereof and upstream from the pump 68. In the illustrated, non-limiting embodiment, the outlet 84 of the recirculation conduit 80 is fluidly connected to the first fluid conduit 61 at a location directly upstream from the inlet of the pump 68.

As shown, a valve CV3 may be arranged along the flow path defined by the recirculation conduit 80. The valve CV3 is operable to control a flow of coolant C through the recirculation conduit 80. When the valve CV3 is at least partially open, the coolant C output from the pump 68 may be divided into a first portion C1 configured to flow to the first heat exchanger 38, and a second portion C2 configured to flow through the recirculation conduit 80 and return to the pump 68.

The controller 100 is operably coupled to the third valve CV3. In an embodiment, the secondary cooling circuit 33 includes at least one sensor, such as a third sensor represented by S3 in FIG. 3, operable to monitor the temperature and/or pressure of the coolant C at a location upstream from the first heat exchanger 38 and downstream from the one or more racks 52 or other components to be cooled by coolant C. This temperature data and/or pressure data may be sensed and communicated to the controller 100 intermittently or continuously. Using the pressure measurements both upstream and downstream from the first heat exchanger 38 collected by sensors S1 and S3, the controller 100 is configured to determine a differential pressure therebetween, such as across the first heat exchanger 38. The controller 100 may be configured to compare the sensed differential pressure with the differential pressure setpoint of the secondary cooling circuit 33. In an embodiment, the controller 100 is then operable to determine at least one operational parameter of the pump 68, such as a speed of the pump 68 for example, to achieve the differential pressure set point.

The controller 100 may have a predefined function that identifies a minimum flow required for stable operation of the pump 68. The predefined function may include a graph, table, or other data set that compares volumetric flow rate to pump pressure for different pump speeds, and indicates what combinations fall within a zone of stable operation of the pump 68 and a zone of instable operation of the pump 68. The controller 100 may be operable to compare the at least one operational parameter of the pump 68 and a volumetric flow rate within the secondary cooling circuit 33 with the graph to determine whether operation of the pump 68 with such parameters would be stable.

If the controller 100 determines that operation of the pump 68 with the at least one operational parameter will generate sufficient pressure to meet the differential pressure set point and therefore is within the zone of stable operation, the at least one operational parameter will be implemented. In an embodiment, the speed of the pump 68 will be adjusted. In addition, the third valve CV3 will remain closed. However, if operation of the pump 68 with the at least one operational parameter is incapable of providing the pressure needed to meet the differential pressure set point, such operation falls within the zone of instability. The controller 100 will therefore adjust operation of the pump 68 to the minimum flow and pressure required to operate within the zone of stability. In addition, the controller 100 will open the third valve CV3 to recirculate a portion of the flow of coolant C output from the pump 68, such as portion C2, to the inlet of the pump 68 to increase the flow and differential pressure to equal the differential pressure setpoint.

Although the first cooling system 30 having the bypass conduit 78 and second valve CV2 and the secondary cooling circuit 33 including a recirculation conduit 80 and valve CV3 are illustrated in different embodiments of the cooling system 20, it should be understood that a cooling system including both a first cooling system 30 having the bypass conduit 78 and second valve CV2 and a secondary cooling circuit 33 including a recirculation conduit 80 and valve CV3 are within the scope of the disclosure.

A first cooling system 30 having a bypass conduit 78 and a second valve CV2 is operable to provide a return flow of heat transfer fluid R having a constant temperature to a downstream load, such as a chiller for example. The first cooling system 30 is operable to achieve the constant temperature of the heat transfer fluid R over a full range of operating loads (0% to 100%). A secondary cooling circuit 33 having a recirculation conduit 80 and corresponding valve V3 as described herein is operable to provide constant available pressure to the rack systems 52 and the components thereof over a full range of operating loads (0% to 100%).

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present invention has been described with reference to an exemplary embodiment or embodiments, it will be understood by those skilled in the art that various changes may be made and equivalents may be substituted for elements thereof without departing from the scope of the present invention as defined by the appended claims. In addition, many modifications may be made to adapt a particular situation or material to the teachings of the present invention without departing from the essential scope thereof. Therefore, it is intended that the present invention not be limited to the particular embodiment disclosed as the best mode contemplated for carrying out this present disclosure, but that the present invention will include all embodiments falling within the scope of the claims.

## Claims

1. A cooling distribution unit associated with at least one rack system of a data center, the cooling distribution unit comprising:
a first cooling system having a primary cooling circuit through which a heat transfer fluid is configured to circulate, the first cooling system including a heat exchanger;
a second cooling system having a secondary cooling circuit through which a coolant is configured to circulate, the secondary cooling circuit including a pump, wherein the second cooling system is thermally coupled to the first cooling system at the heat exchanger; and
wherein a pressure at the pump remains constant as a load at the first heat exchanger varies.

2. The cooling system of claim 1, wherein the load at the cooling distribution unit is controlled via operation of the pump.

3. The cooling system of claim 1 or claim 2, wherein the pump fluidly connected to the secondary cooling circuit is a variable speed pump.

4. The cooling system of any of claims 1-3, wherein a portion of the coolant output from the pump is selectively recirculated to the pump to increase a pressure at the pump.

5. The cooling system of claim 4, further comprising a recirculation conduit having an inlet fluidly connected to the secondary cooling circuit downstream from the pump and an outlet fluidly connected the secondary cooling circuit upstream from the pump; optionally
wherein at least one of the inlet is fluidly connected to the secondary cooling circuit directly downstream from the pump and the outlet is fluidly connected the secondary cooling circuit directly upstream from the pump.

6. The cooling system of claim 5, further comprising a valve arranged along the recirculation conduit, the valve being operable to control a flow of the coolant returned to an inlet of the pump.

7. The cooling system of any of claims 1-6, wherein the pump is operated within a zone of stable operation as the load at the cooling distribution unit varies.

8. The cooling system of claim 7, further comprising a controller, wherein the controller is configured to determine a differential pressure across the heat exchanger.

9. The cooling system of claim 8, further comprising a first sensor arranged within the secondary cooling circuit upstream from the heat exchanger and a second sensor arranged within the secondary cooling circuit downstream from the heat exchanger, wherein the first sensor and the second sensor are operably coupled to the controller and are operable to sense a pressure, a difference between the pressure at the first sensor and the pressure at the second sensor being the differential pressure across the heat exchanger.

10. The cooling system of claim 9, wherein the controller is configured to:
compare the differential pressure with a differential pressure set point to determine a difference between the differential pressure measured by the first sensor and the second sensor and the differential pressure set point; and
adjust at least one operational parameter of the pump in response to the difference between the differential pressure measured by the first sensor and the second sensor and the differential pressure set point; optionally
wherein the at least one operational parameter of the pump is speed.

11. The cooling system of claim 10, wherein the controller is configured to evaluate if operation of the pump with the at least one operational parameter is within the zone of stable operation; optionally
wherein the controller is configured to:
adjust operation of the pump to a minimum flow and pressure required to operate within the zone of stable operation; and
recirculate a portion of the coolant output from the pump to an inlet of the pump to increase a pressure at the pump.

12. A method of operating a cooling distribution unit, the method comprising:
circulating a heat transfer fluid through a primary cooling circuit;
circulating a coolant through a secondary cooling circuit, the secondary cooling circuit including a pump, wherein the cooling distribution circuit and the secondary cooling circuit and thermally coupled via a heat exchanger;
detecting a differential pressure within the secondary cooling circuit, and
selectively recirculating a flow of coolant within the secondary cooling circuit to the pump to maintain a constant pressure within the secondary cooling circuit.

13. The method of claim 12, wherein selectively recirculating a flow of the coolant within the secondary cooling circuit to the pump further comprises diverting a portion of the coolant provided at an outlet of the pump directly to an inlet of the pump.

14. The method of claim 12 or claim 13, further comprising:
comparing the differential pressure to a differential pressure setpoint; and
determining at least one operational parameter of the pump in response to a difference between the differential pressure and a differential pressure set point; optionally
further comprising:
determining that operation of the pump with the at least one operational parameter to determine is within a zone of stable operation associated with the pump; and
implementing the at least one operational parameter; and optionally
further comprising:
determining that operation of the pump with the at least one operational parameter to determine is within a zone of instable operation associated with the pump;
adjusting operation of the pump to a minimum flow and pressure associated with the zone of stable operation; and
opening a valve to recirculate a portion of a flow of the coolant output from the pump to the inlet of the pump.

15. The method of claim 14, wherein the at least one operational parameter of the pump is speed.
